Europäisches Patentamt

European Patent Office

Office européen des brevets

(19)

(11) Publication number: **0 141 649**
**B1**

(12) **EUROPEAN PATENT SPECIFICATION**

(45) Date of publication of patent specification: **07.09.88**

(51) Int. Cl.⁴: **C 30 B 15/14**

(21) Application number: **84307509.4**

(22) Date of filing: **31.10.84**

(54) An apparatus for pulling a single crystal.

(30) Priority: **08.11.83 JP 210568/83**

(43) Date of publication of application:
**15.05.85 Bulletin 85/20**

(45) Publication of the grant of the patent:
**07.09.88 Bulletin 88/36**

(84) Designated Contracting States:
**DE FR GB**

(56) References cited:
**EP-A-0 141 495**
**FR-A-1 515 916**
**US-A-3 039 071**

**PATENTS ABSTRACTS OF JAPAN, vol. 6, no.
73(C-101)(951), 8th May 1982**

(73) Proprietor: **SUMITOMO ELECTRIC INDUSTRIES
LIMITED**
**No. 15, Kitahama 5-chome Higashi-ku
Osaka-shi Osaka 541 (JP)**

(73) Proprietor: **NIPPON TELEGRAPH AND
TELEPHONE CORPORATION**
**1-6 Uchisaiwaicho 1-chome Chiyoda-ku
Tokyo (JP)**

(72) Inventor: **Kawasaki, Akihisa Osaka Works of
Sumitomo Electric
Industries, Ltd. 1-3, Shimaya 1-chome
Konohana-ku Osaka (JP)**
Inventor: **Kishi, Masao Osaka Works of
Sumitomo Electric
Industries, Ltd. 1-3, Shimaya 1-chome
Konohana-ku Osaka (JP)**
Inventor: **Kotani, Toshihiro Osaka Works of
Sumitomo Electric
Industries, Ltd. 1-3, Shimaya 1-chome
Konohana-ku Osaka (JP)**
Inventor: **Nakai, Ryusuke Osaka Works of
Sumitomo Electric
Industries, Ltd. 1-3, Shimaya 1-chome
Konohana-ku Osaka (JP)**
Inventor: **Miyazawa, Shintaro
No. 7-504, 861-1, Ishida
Isehara-shi Kanagawa-ken (JP)**

**0 141 649**

(72) Inventor: **Hoshikawa, Keigo**
**No. 4-104, 861-1, Ishida**
**Isehara-shi Kanagawa-ken (JP)**

(74) Representative: **Horton, Andrew Robert Grant**
**et al**
**Boult, Wade & Tennant 27 Furnival Street**
**London EC4A 1PQ (GB)**

## Description

## BACKGROUND OF THE INVENTION
### 1. Field of the Invention

This invention relates to an apparatus for pulling a single crystal by the Czochralski method (hereinafter referred to as CZ method) or by the Liquid Encapsulated Czochralski method (hereinafter referred to an LEC method).

### 2. Description of the Prior Art

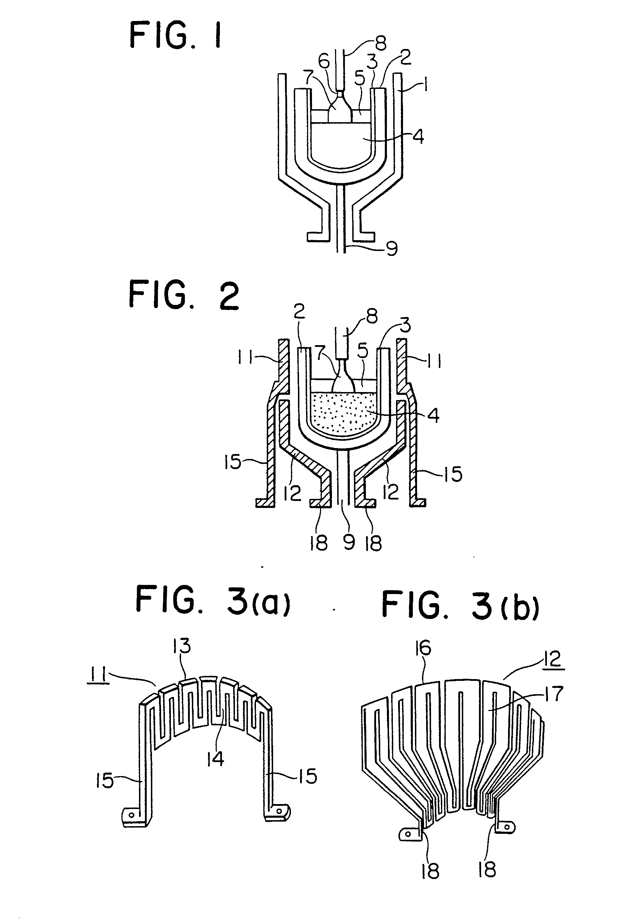

In an apparatus for pulling a single crystal by CZ method or LEC method as shown in Fig. 1, raw material melt 4 (e.g. GaAs) is charged in crucible 3, the surface of which is optionally covered with $B_2O_3$ melt 5 (in the case of LEC method), and seed crystal 6 fitted to pull rod 8 is immersed in the surface of melt 4, wetted and then pulled up to obtain single crystal 7 (e.g. GaAs). 1 is a heater in a furnace, 2 is a susceptor (carbon) and 9 is a crucible support shaft (lower shaft).

In this case, one heater has been used so as to hold a predetermined temperature distribution in the furnace according to the prior art, but this fails to obtain a high quality single crystal because of the following reasons: The temperature distribution on the central axis (vertical direction) of single crystal 7 varies with the time when seeding is carried out, when single crystal 7 comes out of $B_2O_5$ 5 and when the most part of single crystal 7 is pulled up, and for example, the dislocation density (EPD) is thus increased from the seed end to the tail end to a greater extent. As single crystal 7 is pulled out on $B_2O_3$ melt 5, single crystal 7 is cooled by the atmospheric gas (inert gas such as $N_2$ gas) and the temperature gradient in the axial direction of single crystal 7 is increased to cause thermal stress and to increase disclocation density.

When using one heater, however, it is impossible to controllably heat single crystal 7 and raw material melt 4 independently and to hold constant the temperature distribution in the vicinity of the solid-liquid interface from the start to the end of crystal growth. Accordingly, the single crystal cannot be held in a low dislocation density from the seed end to the tail end thereof by the use of one heater as in the prior art.

## SUMMARY OF THE INVENTION

It is an object of the present invention to provide an apparatus for the growth of single crystals, whereby at least some of the above-described disadvantages of the prior art can be overcome.

It is another object of the present invention to provide an apparatus for the Czochralski growth of compound single crystals in which the temperature distribution in the vertical direction can readily be controlled from seeding to pulling-up of a single crystal.

It is a further object of the present invention to provide an apparatus for pulling a single crystal with a low dislocation density from the seed end to the tail end of the single crystal.

It is known from JP—A—57/11897 to provide an apparatus for pulling a single crystal by the Czochralski method, comprising a crucible for holding a melt of raw material for the crystal, means for pulling said raw material from said melt into a single crystal; and heating means comprising an upper heater and a lower heater each provided around said crucible, the upper heating consisting of a rectangular waveform electrical resistance coil formed from a flat faced coil material and wound in a cylindrical form along the outside of the crucible with the flat face of the coil material facing radially, the width direction of the coil being in the axial direction of the crucible, and the lower heater consisting of a rectangular waveform electric resistance coil formed from a flat faced coil material and would along the outside of the lower part of the side of the crucible, the flat face of the coil material facing radially and the width direction of the coil being in the axial direction of the crucible, the end parts of the coil being fixed legs for connection to a power supply.

In JP—A—57—11897 the so-called upper heater is in two-layer, folded form and the lower edge of this heater is below the upper edge of the lower heater.

The present invention is characterised in that the lower heater is wound in funnel form so as to extend under the bottom of the crucible; the end parts of the upper coil extend downward along the outside of the lower heater in the form of fixed legs for connection to a power supply and the upper edge of the lower heater and the lower edge of the upper heater are juxtaposed, the lower edge of the upper heater being in use of the apparatus substantially at the level of the solid-liquid interface of the material drawn from the crucible.

EP—0141495 (published 15th May 1985) discloses apparatus for pulling a single crystal by the Czochralski method and comprising a crucible for holding a melt of raw material for the crystal, means for pulling the raw material from the melt into a single crystal and a heating means comprising an upper heater and a lower heater separated in the vicinity of the solid-liquid interface.

## BRIEF DESCRIPTION OF THE DRAWINGS

The accompanying drawings illustrate the principles and merits of the present invention in more detail.

Fig. 1 is a vertical-sectional view of one example of an apparatus for pulling a single crystal according to the prior art.

Fig. 2 is a vertical-sectional view of one embodiment of an apparatus for pulling a single crystal according to the present invention.

Fig. 3(a) and (b) are perspective views of examples of the upper heater and lower heater as shown in Fig. 2.

Fig. 4 is a graph showing the etch pit density distributions on the seed ends and the tail ends of single crystals prepared according to the present invention and the prior art.

DETAILED DESCRIPTION OF THE INVENTION

The inventors have made various efforts to develop an apparatus for the Czochralski growth of a single crystal with a lowered dislocation density from the seed end to the tail end of the single crystal and consequently have found that such a single crystal can be obtained by the use of a single crystal pulling apparatus provided with two-stage heater comprising an upper heater and a lower heater, whereby the temperature distribution in the vertical direction can readily be controlled. The present invention is based on this finding.

Single crystals pulled by the apparatus of the present invention include compounds of Group III—V elements of Periodic Table (e.g. GaAs, InAs, Inp, etc.), compounds of Group II—VI elements (e.g. ZnSe, etc.) or their mixed crystals, elementary semiconductors such as Si and Ge, and other single crystals of oxides, nitrides, carbides and the like. In particular, the apparatus of the present invention can be applied with larger merits to the LEC method in which control of the temperature gradient is difficult because of pulling a single crystal at a high pressure, e.g. $2 \times 10^5$ Pa to $6 \times 10^6$ Pa (2 to 60 atm) using $B_2O_3$ melt.

The present invention will now be illustrated as to one preferred embodiment referring to the accompanying drawings. Fig. 2 is a vertically sectional view of one example of the apparatus of the present invention, in which the same numerals show the same parts as those of Fig. 1. The difference between Fig. 1 and Fig. 2 is that the heating means provided at the side of a furnace is divided at a part of the side of crucible 3 into a two-stage heater, comprising an upper heater 11 and a lower heater 12. Upper heater 11 is used mainly for the purpose of controlling the temperature in the vicinity of the solid-liquid interface and that of pulled single crystal 7, while lower heater 12 is used mainly for the purpose of controlling the temperature of raw material melt 4.

Upper heater 11 has such a structure as shown in Fig. 3(a), while lower heater 12 has a structure as shown in Fig. 3(b). Upper heater 11 consists of a rectangular waveform coil 13 wound in a cylindrical form along the outside of crucible 3, the width direction (direction of longer side 14) of the coil being vertical, i.e. in the axial direction of crucible 3. End parts 15 and 15 of coil 13 extend downwards along the outside of lower heater 12, form fixed legs of coil 13 and connect with respective terminals, on the other hand, lower heater 12 consists of rectangular waveform coil 16 wound in a funnel form along the outside of the side and bottom of crucible 3, the width direction (direction of longer side 17) of the coil being vertical, i.e. in the axial direction of crucible 3. End parts 18 and 18 form fixed legs of coil 16 and connect with respective terminals. The above-described coils may be made of graphite, carbon or glassy carbon.

When upper and lower heaters 11 and 12 are constructed of such rectangular waveform coils 13 and 16, the temperature of raw material melt 4 and single crystal 7 may readily be stabilized. The heating coils may be of plate or strip form with a large surface area. The temperature distribution can readily be changed by changing the dimensions of the heating coils. Upper and lower heaters 11 and 12 may be controlled individually or in combination, whereby the temperature in the vertical direction can readily be controlled to give a predetermined temperature distribution from seeding of a single crystal to the finish of pulling the same.

One preferred embodiment of pulling a single crystal by means of the apparatus of the present invention will be given below:

Firstly, the power ratio (calorific power) of heaters 11 and 12 is changed to seek conditions capable of giving a small temperature gradient (e.g. 5 to 100°C/cm) in the central portion of $B_2O_3$ melt 5 in the vertical direction. Under these conditions, seeding is started and when single crystal 7 comes out of $B_2O_3$ melt 5 and is exposed to a high pressure gas, single crystal 7 is warmed by upper heater 11 with observing the growth of the diameter of single crystal 7 and pulling of the single crystal is continued with keeping the temperature gradient in the vertical direction near the solid-liquid interface is maintained at, for example, 5 to 100°C/cm.

When the power of upper heater 11 is increased and single crystal 7 becomes smaller, the power of lower heater 12 is somewhat decreased and pulling is continued to maintain the diameter of single crystal 7. The power ratio as described above depends on the heater structure, but, for example, it is in the range of an upper to lower ratio of 1 to 2 to obtain a temperature gradient of 5 to 60°C/cm.

Since a heater for heating the inside of a furnace is divided in two stages which can be controlled individually or in combination as described above, control of the temperature distribution during growth of a single crystal can readily be carried out to hold constant the diameter of the single crystal grown.

The apparatus for pulling a single crystal according to the present invention, as illustrated above, has the following advantages:

Since a heater provided for heating the inside of a furnace is constructed of two-stage heater comprising an upper heater and a lower heater, which can be cotrolled independently, it is possible to control the temperature gradient freely in the vertical direction in the vicinity of the solid-liquid interface and to keep small and constant the temperature gradient from the start to the end of pulling the single crystal. In addition, since the each heater consists of a rectangular waveform coil whose width direction is vertical, control of the temperature of a raw material melt and a single crystal is readily feasible due to the larger heating area of the coil and the temperature gradient at the solid-liquid interface can be kept small and correctly constant from the start to the end of the crystal growth, thus preventing formation of dislocations due to thermal stress. Therefore, the use of the apparatus according to the present invention results in production of a high quality single crystal with a low dislocation density and a uniformity of dislocation densities from the seed end to the tail end of the single crystal in a high yield.

Moreover, it is important that, for example, an LED fabricated on a wafer with a large dislocation density has a short life, a semi-insulating single crystal of GaAs (undoped or Cr-doped) has a strong relationship between the dislocation density and resistance and the yield of a device is greatly affected by the dislocation density. Accordingly, the apparatus of the present invention may advantageously increase the yield of such devices and has important significances in these uses.

The following example is given in order to illustrate the present invention without limiting the same.

### Example

GaAs single crystal was pulled using the apparatus of the present invention, as exemplified in Fig. 2. This apparatus had the following dimensions:

Length of coil 13 of upper heater 11 = 70 mm
Total height of upper heater 11 = 250 mm
Height of coil 16 of lower heater 12 = 150 mm
Length of vertical part of coil 16 = 100 mm
Inner diameter of coil = 190 mm$\phi$
Outer diameter of coil = 210 mm$\phi$
Material of coil = carbon

About 5 kg of GaAs polycrystal raw material and 500 g of $B_2O_3$ were charged in a quartz crucible of 150 mm in diameter, melted and pulled in a <001> direction at a pressure of $10^6$ Pa (10 kg/cm$^2$) in a furnace, a pulling rate of 12 mm/hr, a curcible raising rate of 1 mm/hr, a pull rod 8 and crucible support rod 9 revolving rate of 10 rpm and a temperature gradient of about 20°C/cm, the temperature gradient being in the vertical direction near the solid-liquid interface during seeding, thus obtaining a GaAs single crystal of 50 mm in diameter and about 500 mm in length. During the growth of the single crystal, the temperature gradient was held at 20°C/cm. The electric power applied to the both heaters was respectively 10 kW.

For comparison, a single crystal was similarly prepared but using a pulling apparatus of the prior art, provided with only one heater.

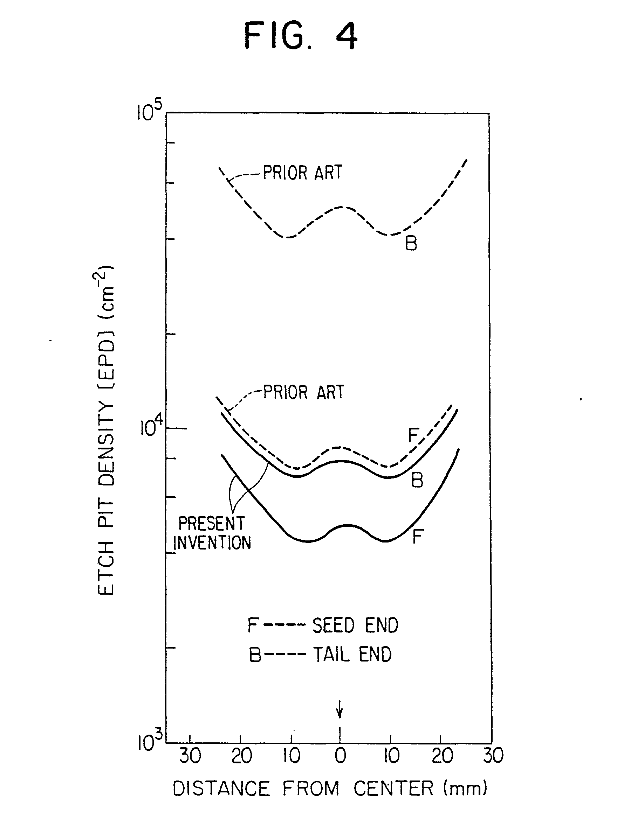

(001) wafers cut from the seed end (F) and the tail end (B) of the single crystal were subjected to etching with molten KOH and to measurement of the etch pit density (EPD), thus obtaining results as shown in Fig. 4, in which solid lines showed EPD when using the two stage heaters of the present invention and dotted lines showed EPD when using the one stage heater of the prior art; Ordinate: EPD (cm$^{-2}$) and Abscissa: distance (mm) from center of wafer. EPD was measured at points in <001> direction on (001) wafers. The mean EPD was as shown in Table 1:

TABLE 1

Mean EPD ($\times$ 10$^4$ cm$^{-2}$)

|  | Seed End (F) | Tail End (B) |
|---|---|---|
| Present Invention | 0.6 | 0.9 |
| Prior Art | 0.9 | 5 |

As is evident from the results of Fig. 4 and Table 1, EPD is lower and is scarcely changed from the seed end to the tail end in the present invention, while EPD is remarkably increased from the seed end to the tail end in the prior art.

### Claims

1. An apparatus for pulling a single crystal by the Czochralski method, comprising: a crucible (3) for holding a melt of raw material (4) for the crystal; means (8) for pulling said raw material from said melt into a single crystal; and a heating means comprising an upper heater (11) and a lower heater (12) each provided around said crucible, the upper heater consisting of a rectangular waveform electric resistance coil (13, 14) formed from a flat faced coil material and would in a cylindrical form along the outside of the crucible with the flat face of the coil material facing radially, the width direction of the coil being in the axial direction of the crucible, the lower heater (12) consisting of a rectangular waveform electric resistance coil (16, 17) formed from a flat faced coil material and wound along the outside of the lower part of the side of the crucible with the flat face of the coil material facing radially, the width direction of the coil being in the axial direction of the crucible and the end parts of the coil being fixed legs (18) for connection to a power supply; characterised in that the lower heater is wound in funnel form so as to extend under the bottom of the crucible; the end parts of the upper coil extend downward along the outside of the lower heater in the form of fixed legs (15) for connection to a power supply; and the upper edge of said lower heater and the lower edge of said upper heater are juxtaposed, the lower edge of the upper heater being in use of the apparatus substantially at the level of the solid-liquid interface of the material being drawn from the crucible.

2. A process of pulling a single crystal by the Czochralski method, comprising employing apparatus according to claim 1, controlling the temperature of the melt of raw material by means of the lower heater and controlling the temperature of the pulled crystal and that of the solid-liquid interface by means of the upper heater so as to maintain a temperature gradient at the solid-liquid interface of between 5 and 60°C/cm.

**Patentansprüche**

1. Vorrichtung zum Ziehen eines Einkristalls nach dem Czochralski-Verfahren, mit einem Tiegel (3) zum Halten einer Schmelze aus Rohmaterial (4) für den Kristall, mit Einrichtungen (8) zum Ziehen des Rohmaterials aus der Schmelze zu einem Einkristall und mit einer Heizeinrichtung, die eine obere Beheizung (11) und eine untere Beheizung (12) aufweist, von denen jedge um den Tiegel herum vorgesehen ist, von denen die obere Beheizung aus einer elektrischen Widerstandsspule (13, 14) mit Rechteckswellenform besteht, die aus einem ebenflächigen Spulenmaterial hergestellt und zu einer zylindrischen Form längs der Außenseite des Tiegels gewunden ist, wobei die ebene Fläche des Spulenmaterials radial gerichtet ist und die Breitenrichtung der Spule in Axialrichtung des Tiegels liegt, und von denen die untere Beheizung (12) aus einer elektrischen Widerstandsspule (16, 17) mit Rechteckswellenform besteht, die aus einem ebenflächigem Spulenmaterial hergestellt und längs der Außenseite des unteren Teils der Seite des Tiegels gewunden ist, wobei die ebene Fläche des Spulenmatrials radial gerichtet ist und die Breitenrichtung der Spule in Axialrichtung des Tiegels liegt, und wobei die Endteile der Spule festgelegte Füße (18) zur Verbindung mit einer Stromquelle sind, dadurch gekennzeichnet, daß die untere Beheizung trichterförmig gelegt ist, so daß sie sich unter den Boden des Tiegels erstreckt, daß sich die Endteile der oberen Spule nach unten längs der Außenseite der unteren Beheizung in Form von festgelegten Füßen (15) für die Verbindung mit einer Stromquelle erstrecken und daß der obere Rand der unteren Beheizung und der untere Rand der oberen Beheizung nebeneinander angeordnet sind, wobei der untere Rand der oberen Heizung beim Einsatz der Vorrichtung im wesentlichen auf der Höhe der Fest-Flüssig-Trennfläche des aus dem Tiegel zu ziehenden Material sliegt.

2. Verfahren zum Ziehen eines Einkristalls nach dem Czochralski-Verfahren unter Verwendung einer Vorrichtung nach Anspruch 1, bei welchem die Temperatur der Schmelze des Rohmaterials mit Hilfe der unteren Beheizung und die Temperatur des gezogenen Kristalls und die der Fest-Flüssig-Trennfläche mit Hilfe der oberen Beheizung so gesteuert wird, daß an der Fest-Flüssig-Trennfläche ein Temperaturgradient zwischen 5 und 60°C/cm aufrechterhalten wird.

**Revendications**

1. Appareillage pour le tirage d'un monocristal par la méthode de Czochralski, comprenant: un creuset (3) destiné à contenir un bain en fusion de la matière première (4) du cristal; un moyen (8) pour tirer ladite matière première dudit bain en fusion et la transformer en un monocristal; et un moyen de chauffage, comprenant un élément chauffant supérieur (11) et un élément chauffant inférieur (12), chacun d'eux étant installé autour dudit creuset, l'élément chauffant supérieur étant constitué d'une bobine de résistance électrique (13, 14), ayant la forme d'une onde rectangulaire, façonnée à partir d'un matériau pour bobine à face plane et enroulée selon un cylindre le long du côté extérieur du creuset, la face plane du matériau pour bobine étant dirigée radialement, la largeur de la bobine étant dirigée dans le sens axial du creuset, l'élément chauffant inférieur (12) étant constitué d'une bobine de résistance électrique (16, 17), ayant la forme d'une onde rectangulaire, façonnée à partir d'un matériau pour bobine à face plane et enroulée autour de l'extérieur de la partie inférieure du côté du creuset vers laquelle regarde radialement la face plane du matériau pour bobine, la largeur de la bobine étant dirigée dans le sens axial du creuset, et les parties terminales de la bobine étant des pattes fixes (18) destinées à un raccordement à une alimentation en courant; caractérisé en ce que l'élément chauffant inférieur est enroulé pour prendre la forme d'un entonnoir de façon à s'étendre en-dessous du fond du creuset; les parties terminales de la bobine supérieure s'étendent vers le bas, le long du côté extérieur de l'élément chauffant inférieur, sous forme de pattes fixes (15) destinées à un raccordement à une alimentation en courant; et le bord supérieur dudit élément chauffant inférieur et le bord inférieur dudit élément chauffant supérieur sont juxtaposés, le bord inférieur de l'élément chauffant supérieur étant, quand l'appareillage est en cours d'utilisation, pratiquement au niveau de l'interface solide-liquide du matériau que l'on tire du creuset.

2. Procédé de tirage d'un monocristal par la méthode de Czochralski, consistant à utiliser un appareillage selon la revendication 1, à réguler la température du bain en fusion de matière première au moyen de l'élément chauffant inférieur, et à réguler la température du cristal tiré et celle de l'interface solide-liquide au moyen de l'élément chauffant supérieur, de façon à maintenir à l'interface solide-liquide un gradient de température compris entre 5 et 60°C/cm.

# FIG. 1

# FIG. 2

# FIG. 3(a)          FIG. 3(b)

1

# FIG. 4